(19) **Europäisches Patentamt**
**European Patent Office**
**Office européen des brevets**

(11) **EP 4 554 117 A1**

(12) **EUROPEAN PATENT APPLICATION**
published in accordance with Art. 153(4) EPC

(43) Date of publication:
14.05.2025 Bulletin 2025/20

(51) International Patent Classification (IPC):
*H04B 10/50* (2013.01)

(21) Application number: 23849145.0

(52) Cooperative Patent Classification (CPC):
H01S 5/042; H04B 10/50

(22) Date of filing: 30.06.2023

(86) International application number:
PCT/CN2023/105355

(87) International publication number:
WO 2024/027435 (08.02.2024 Gazette 2024/06)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 05.08.2022 CN 202210937548

(71) Applicant: Huawei Technologies Co., Ltd.
Shenzhen, Guangdong 518129 (CN)

(72) Inventors:
• JIANG, Fang
  Shenzhen, Guangdong 518129 (CN)
• LIN, Youxi
  80992 Duesseldorf (DE)
• SUN, Xiaobin
  Shenzhen, Guangdong 518129 (CN)

(74) Representative: Isarpatent
Patent- und Rechtsanwälte
Barth Hassa Peckmann & Partner mbB
Friedrichstraße 31
80801 München (DE)

(54) **OPTICAL SENDING MODULE, OPTICAL SENDING DEVICE, AND METHOD FOR ADJUSTING PILOT-TUNE DEPTH**

(57) This application provides an optical transmitter module, used in the field of optical communication. The optical transmitter module includes a laser, a photoelectric detector, a processor, and a driving circuit. The laser is configured to output a forward optical signal and a backward optical signal based on a driving signal of the driving circuit, where the forward optical signal and the backward optical signal carry a pilot tone modulation signal. The photoelectric detector is configured to convert the backward optical signal into an analog electrical signal. The processor is configured to convert the analog electrical signal into a digital electrical signal. The processor is further configured to obtain a pilot tone modulation depth of the pilot tone modulation signal based on the digital electrical signal, and change the driving signal based on the pilot tone modulation depth. The driving circuit is configured to drive the laser based on a changed driving signal. **In** this application, the pilot tone modulation depth of the pilot tone modulation signal is adjusted by using the backward optical signal of the laser, so that impact of an operating temperature change or aging of the laser on the pilot tone modulation depth can be reduced, thereby improving communication reliability.

FIG. 1

EP 4 554 117 A1

**Description**

This application claims priority to Chinese Patent Application No. 202210937548.3, filed with the China National Intellectual Property Administration on August 5, 2022 and entitled "OPTICAL TRANSMITTER MODULE, OPTICAL TRANSMITTING DEVICE, AND METHOD FOR ADJUSTING PILOT TONE MODULATION DEPTH", which is incorporated herein by reference in its entirety.

**TECHNICAL FIELD**

This application relates to the field of optical communication, and in particular, to an optical transmitter module, an optical transmitting device, and a method for adjusting a pilot tone modulation depth.

**BACKGROUND**

In the field of optical communication, a low-speed pilot tone modulation signal may be modulated on a high-speed service signal. The pilot tone modulation signal can be used for remote information monitoring, fault locating, intelligent operation and maintenance, and the like.

A pilot tone modulation depth represents a ratio of energy of the pilot tone modulation signal to energy of the service signal. The pilot tone modulation depth affects reliability of pilot tone modulation communication and service communication. Specifically, an excessively large pilot tone modulation depth causes a signal-to-noise ratio of the service signal to deteriorate, affecting accuracy of the service signal. An excessively small pilot tone modulation depth causes a signal-to-noise ratio of the pilot tone modulation signal to deteriorate, affecting accuracy of the pilot tone modulation signal. In an optical communication system, to control the pilot tone modulation depth, a pilot tone modulation depth of a laser is calibrated by using a calibration device (such as an oscilloscope) before delivery.

In an actual application, a calibrated pilot tone modulation depth changes with an operating temperature or aging of the laser, affecting communication reliability.

**SUMMARY**

This application provides an optical transmitter module, an optical transmitting device, and a method for adjusting a pilot tone modulation depth. A pilot tone modulation depth of a pilot tone modulation signal is adjusted by using a backward optical signal of a laser, so that impact of an operating temperature change or aging of the laser on the pilot tone modulation depth can be reduced, thereby improving communication reliability.

A first aspect of this application provides an optical transmitter module. The optical transmitter module includes a laser, a photoelectric detector, a processor, and a driving circuit. The laser is configured to output a forward optical signal and a backward optical signal based on a driving signal of the driving circuit. The forward optical signal and the backward optical signal carry a pilot tone modulation signal. The pilot tone modulation signal is obtained based on the driving signal. The photoelectric detector is configured to convert the backward optical signal into an analog electrical signal. The processor is configured to convert the analog electrical signal into a digital electrical signal. The processor is further configured to obtain a pilot tone modulation depth of the pilot tone modulation signal based on the digital electrical signal, and change the driving signal based on the pilot tone modulation depth. The driving circuit is configured to drive the laser based on a changed driving signal.

In an optional manner of the first aspect, the optical transmitter module further includes an amplifier. The amplifier is configured to amplify the analog electrical signal. A digital-to-analog converter is configured to convert an amplified analog electrical signal into the digital electrical signal. In an actual application, a power of the backward optical signal is relatively low. By amplifying the analog electrical signal, accuracy of the digital electrical signal obtained through conversion can be improved, thereby improving accuracy of an adjusted pilot tone modulation depth. Therefore, in this application, communication reliability can be improved.

In an optional manner of the first aspect, the optical transmitter module further includes a filter. The filter is configured to filter the analog electrical signal. The digital-to-analog converter is configured to convert a filtered analog electrical signal into the digital electrical signal. The pilot tone modulation signal is a low-frequency signal. In an actual application, the analog electrical signal may further include a high-frequency service signal and a glitch signal. By introducing the filter, impact of the service signal and the glitch signal on the pilot tone modulation signal can be reduced, thereby improving accuracy of the digital electrical signal obtained through conversion. Therefore, in this application, the accuracy of the adjusted pilot tone modulation depth can be improved, thereby improving the communication reliability.

In an optional manner of the first aspect, the processor is configured to change the driving signal based on the pilot tone modulation depth and a target pilot tone modulation depth range. The pilot tone modulation depth is not within the target pilot tone modulation depth range. When the pilot tone modulation depth is not within the target pilot tone modulation depth range, the processor is configured to change the driving signal of the driving circuit based on the pilot tone modulation depth and the target pilot tone modulation depth range. When the pilot tone modulation depth is within the target pilot tone modulation depth range, the processor does not need to change the driving signal of the driving circuit. Therefore, in this application, workload of the processor can be reduced, thereby saving processing resources of the processor.

In an optional manner of the first aspect, the processor is further configured to receive a target signal. The target signal indicates that a received bit error rate or a signal-to-noise ratio of the pilot tone modulation signal does not satisfy a first condition. The processor is further configured to adjust the target pilot tone modulation depth range based on the target signal, to increase an average pilot tone modulation depth of the pilot tone modulation signal. Affected by quality of a communication link and an optical receiving device, an acceptance range of the optical receiving device for the pilot tone modulation depth may be different. In this application, the target pilot tone modulation depth range is adjusted, so that the communication reliability can be improved.

In an optional manner of the first aspect, the processor is further configured to receive a power-on signal. The processor is configured to change the driving signal based on the pilot tone modulation depth and the power-on signal, to increase the pilot tone modulation depth of the pilot tone modulation signal. When the optical transmitter module is just powered on, the optical transmitter module needs to transmit a handshake signal to the optical receiving device by using the pilot tone modulation signal. In this application, increasing the pilot tone modulation depth helps improve a handshake success rate.

In an optional manner of the first aspect, the processor is further configured to receive a target alert. The target alert includes any one or more of the following alerts: an alert of an excessively high optical power of the laser, an alert of an excessively low optical power of the laser, an alert of a loss of service information, and an alert of a sudden power failure. The processor is configured to change the driving signal based on the pilot tone modulation depth and the target alert, to increase the pilot tone modulation depth of the pilot tone modulation signal. The pilot tone modulation signal carries related information of the target alert. The pilot tone modulation depth is increased, so that a success rate of transmitting the target alert to the optical receiving device can be improved. Even if the optical transmitter module cannot send data subsequently, maintenance personnel can determine a fault location based on the target alert. Therefore, in this application, operation and maintenance efficiency can be improved.

In an optional manner of the first aspect, the processor is further configured to obtain a first threshold current of the laser based on the driving signal and the pilot tone modulation depth. The processor is further configured to obtain a second threshold current of the laser, and generate a service life warning of the laser based on the first threshold current and the second threshold current. The first threshold current and the second threshold current satisfy a second condition. The service life warning is generated, so that operation and maintenance personnel can replace the laser in advance to ensure normal service communication. Therefore, in this application, communication reliability can be improved.

A second aspect of this application provides an optical transmitter module. The optical transmitter module includes a laser, a photoelectric detector, a processor, and a driving circuit. The laser is configured to output a forward optical signal and a backward optical signal based on a driving signal of the driving circuit. The forward optical signal and the backward optical signal carry a pilot tone modulation signal. The pilot tone modulation signal is obtained based on the driving signal. The photoelectric detector is configured to convert the backward optical signal into an analog electrical signal. The processor is configured to convert the analog electrical signal into a digital electrical signal. The processor is further configured to obtain a pilot tone modulation depth of the pilot tone modulation signal based on the digital electrical signal. The processor is further configured to obtain a first threshold current of the laser based on the pilot tone modulation depth and the driving signal. Similarly, at another moment, the processor is further configured to obtain a second threshold current of the laser. The processor is further configured to generate a service life warning of the laser based on the first threshold current and the second threshold current. The first threshold current and the second threshold current satisfy a second condition. The service life warning is generated, so that operation and maintenance personnel can replace the laser in advance to ensure normal service communication. Therefore, in this application, communication reliability can be improved.

A third aspect of this application provides an optical transmitting device. The optical transmitting device includes a service signal processor and the optical transmitter module according to the first aspect, any optional manner of the first aspect, or the second aspect. The service signal processor is configured to transmit a service electrical signal to the optical transmitter module. The optical transmitter module is configured to output a forward optical signal and a backward optical signal based on the service electrical signal. The forward optical signal and the backward optical signal carry a service signal. The service signal is obtained based on the service electrical signal.

A fourth aspect of this application provides a method for adjusting a pilot tone modulation depth. The method for adjusting a pilot tone modulation depth may be applied to an optical transmitter module or an optical transmitting device. The following uses the optical transmitting device as an example for description. The optical transmitting device outputs a forward optical signal and a backward optical signal based on a driving signal. The forward optical signal and the backward optical signal carry a pilot tone modulation signal. The pilot tone modulation signal is obtained based on the driving signal.

The optical transmitting device converts the backward optical signal into an analog electrical signal. The optical transmitting device converts the analog electrical signal into a digital electrical signal. The optical transmitting device obtains a pilot tone modulation depth of the pilot tone modulation signal based on the digital electrical signal. The optical transmitting device changes the driving signal based on the pilot tone modulation depth.

In an optional manner of the fourth aspect, the method for adjusting a pilot tone modulation depth further includes the following steps. The optical transmitting device amplifies the analog electrical signal. The optical transmitting device converts an amplified analog electrical signal into the digital electrical signal.

In an optional manner of the fourth aspect, the method for adjusting a pilot tone modulation depth further includes the following steps. The optical transmitting device filters the analog electrical signal. The optical transmitting device converts a filtered analog electrical signal into the digital electrical signal.

In an optional manner of the fourth aspect, the optical transmitting device changes the driving signal based on the pilot tone modulation depth and a target pilot tone modulation depth range. The pilot tone modulation depth is not within the target pilot tone modulation depth range.

In an optional manner of the fourth aspect, the method for adjusting a pilot tone modulation depth further includes the following steps. The optical transmitting device receives a target signal. The target signal indicates that a received bit error rate or a signal-to-noise ratio of the pilot tone modulation signal does not satisfy a first condition. The optical transmitting device adjusts the target pilot tone modulation depth range based on the target signal, to increase an average pilot tone modulation depth of the pilot tone modulation signal.

In an optional manner of the fourth aspect, the method for adjusting a pilot tone modulation depth further includes the following steps. The optical transmitting device receives a power-on signal. The optical transmitting device changes the driving signal based on the pilot tone modulation depth and the power-on signal, to increase the pilot tone modulation depth of the pilot tone modulation signal.

In an optional manner of the fourth aspect, the method for adjusting a pilot tone modulation depth further includes the following step. The optical transmitting device receives a target alert. The target alert includes any one or more of the following alerts: an alert of an excessively high output optical power of a laser, an alert of an excessively low output optical power of the laser, an alert of a loss of service information, and an alert of a sudden power failure. The optical transmitting device includes the laser. The optical transmitting device changes the driving signal based on the pilot tone modulation depth and the target alert, to increase the pilot tone modulation depth of the pilot tone modulation signal. The pilot tone modulation signal carries related information of the target alert.

In an optional manner of the fourth aspect, the method for adjusting a pilot tone modulation depth further includes the following steps. The optical transmitting device outputs a changed forward optical signal and a changed backward optical signal based on a changed driving signal. The changed forward optical signal and the changed backward optical signal carry a changed pilot tone modulation signal. The optical transmitting device converts the changed backward optical signal into a changed analog electrical signal. The optical transmitting device converts the changed analog electrical signal into a changed digital electrical signal. The optical transmitting device obtains a changed pilot tone modulation depth based on the changed digital electrical signal. The optical transmitting device changes the changed driving signal based on the changed pilot tone modulation depth. In this application, the optical transmitting device may periodically adjust the driving signal. The driving signal is periodically adjusted, so that impact of an operating temperature change or aging of the laser on the pilot tone modulation depth can be further reduced, thereby improving communication reliability.

In an optional manner of the fourth aspect, the method for adjusting a pilot tone modulation depth further includes the following steps. The optical transmitting device obtains a first threshold current based on the driving signal and the pilot tone modulation depth. The optical transmitting device obtains a second threshold current based on the changed driving signal and the changed pilot tone modulation depth. The optical transmitting device generates a service life warning based on the first threshold current and the second threshold current. The first threshold current and the second threshold current satisfy a second condition.

A fifth aspect of this application provides a method for generating a service life warning. The method for generating a service life warning may be applied to an optical transmitting module or an optical transmitting device. The following uses the optical transmitting device as an example for description. The method for generating a service life warning by the optical transmitting device includes the following steps. The optical transmitting device outputs a forward optical signal and a backward optical signal based on a driving signal and a laser. The forward optical signal and the backward optical signal carry a pilot tone modulation signal. The pilot tone modulation signal is obtained based on the driving signal. The optical transmitting device converts the backward optical signal into an analog electrical signal. The optical transmitting device converts the analog electrical signal into a digital electrical signal. The optical transmitting device obtains a pilot tone modulation depth of the pilot tone modulation signal based on the digital electrical signal. The optical transmitting device is further configured to obtain a first threshold current of the laser based on the pilot tone modulation depth and the driving signal. Similarly, at another moment, the optical transmitting device obtains a second threshold current of the laser. The optical transmitting device generates a service life warning of the laser based on the first threshold current and the second threshold current. The first threshold current and the second threshold current satisfy a second condition.

**BRIEF DESCRIPTION OF DRAWINGS**

FIG. 1 is a first diagram of a structure of an optical transmitter module according to an embodiment of this application;
FIG. 2 is a second diagram of a structure of an optical transmitter module according to an embodiment of this application;
FIG. 3 is a third diagram of a structure of an optical transmitter module according to an embodiment of this application;
FIG. 4 is a fourth diagram of a structure of an optical transmitter module according to an embodiment of this application;
FIG. 5 is a diagram of a structure of an optical transmitting device according to an embodiment of this application;
FIG. 6 is a diagram of a structure of an optical communication system according to an embodiment of this application;
FIG. 7 is a schematic flowchart of a method for adjusting a pilot tone modulation depth according to an embodiment of this application; and
FIG. 8 is a schematic flowchart of a method for generating a service life warning according to an embodiment of this application.

**DESCRIPTION OF EMBODIMENTS**

This application provides an optical transmitter module, an optical transmitting device, and a method for adjusting a pilot tone modulation depth. A pilot tone modulation depth of a pilot tone modulation signal is adjusted by using a backward optical signal of a laser, so that impact of an operating temperature change or aging of the laser on the pilot tone modulation depth can be reduced, thereby improving communication reliability.

It should be understood that "first", "second", "target", and the like used in this application are merely for differentiation and description, but cannot be understood as an indication or implication of relative importance or an indication or implication of a sequence. In addition, for brevity and clarity, reference numbers and/or letters are repeated in a plurality of accompanying drawings of this application. Repetition is not indicative of a strict limiting relationship between various embodiments and/or configurations.

The optical transmitter module in this application is used in the field of optical communication. In the field of optical communication, a low-speed pilot tone modulation signal may be modulated on a high-speed service signal. To control a pilot tone modulation depth of the pilot tone modulation signal, a pilot tone modulation depth of a laser may be calibrated through an external device before delivery. However, the calibrated pilot tone modulation depth deteriorates as an operating temperature changes or the laser ages, affecting communication reliability.

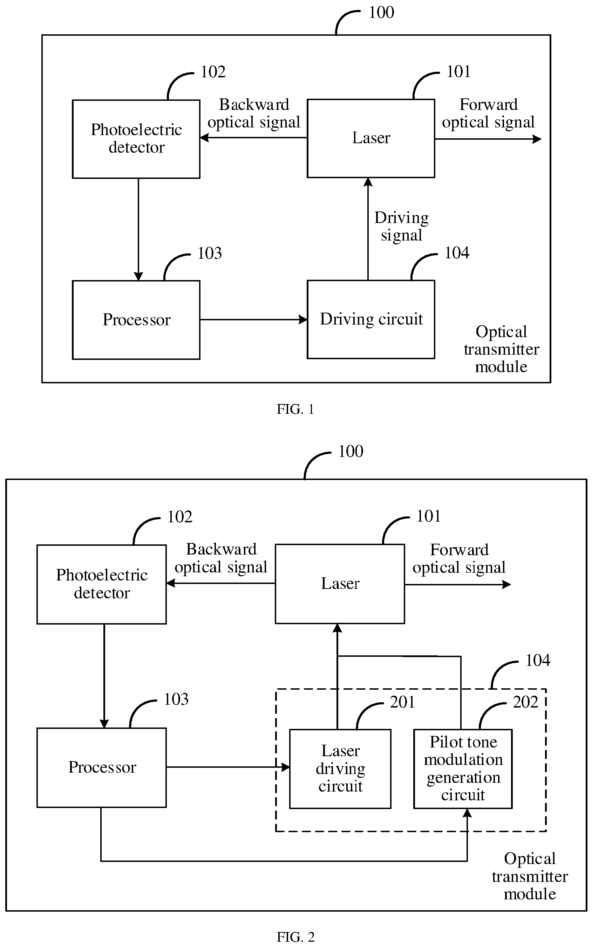

In view of this, this application provides an optical transmitter module. FIG. 1 is a first diagram of a structure of an optical transmitter module according to an embodiment of this application. As shown in FIG. **1,** the optical transmitter module 100 includes a laser 101, a photoelectric detector 102, a processor 103, and a driving circuit 104.

The laser 101 may be a directly modulated laser or an externally modulated laser. The directly modulated laser is also referred to as a direct modulation laser. The directly modulated laser may be a distributed feedback (distributed feedback, DFB) laser, a vertical cavity surface emitting laser (vertical cavity surface emitting laser, VCSEL), or the like. An external modulator is required for the externally modulated laser. The externally modulated laser may be an electro-absorption modulated laser, a direct current laser, or the like. The laser 101 is configured to output a forward optical signal and a backward optical signal based on a driving signal of the driving circuit 104. The driving signal is used for generating a pilot tone modulation signal. The driving signal may include any one or more of the following content: a pilot tone modulation current, a modulation current, and a bias current. In an actual application, when the laser 101 is a directly modulated laser, the laser 101 may be further configured to receive a service electrical signal. The service electrical signal is also referred to as a modulation signal. The service electrical signal is used for generating a service signal. The forward optical signal and the backward optical signal carry same information. Therefore, the forward optical signal and the backward optical signal each include the pilot tone modulation signal and the service signal.

The photoelectric detector 102 may be a monitoring photodiode (monitoring photodiode, MPD). The photoelectric detector 102 is configured to convert the backward optical signal into an analog electrical signal. In an actual application, the photoelectric detector 102 and the laser 101 may be packaged inside an optical transmitter.

The processor 103 may be a micro control unit (micro control unit, MCU), a digital signal processor (digital signal processor, DSP), a field programmable gate array (field programmable gate array, FPGA), or the like. The processor 103 is configured to receive the analog electrical signal from the photoelectric detector 102, and convert the analog electrical signal into a digital electrical signal. The processor 103 is further configured to obtain a pilot tone modulation depth of the pilot tone modulation signal based on the digital electrical signal. A pilot tone modulation depth represents a ratio of energy of the pilot tone modulation signal to energy of the service signal. The processor 103 may obtain a pilot tone modulation depth H according to the following Formula 1:

$$H = \frac{P1 - P0}{P1 + P0} \qquad \text{Formula 1}$$

P1 represents a large optical signal amplitude of the pilot tone modulation signal. P0 represents a small optical signal amplitude of the pilot tone modulation signal. In an actual application, the processor 103 may obtain a power or an amplitude value of the digital electrical signal. The power or the amplitude value includes P1, P0, and an average power (P1+P0)/2. The processor 103 obtains the pilot tone modulation depth H based on any two values of the power or the amplitude value.

The processor 103 is further configured to change the driving signal of the driving circuit 104 based on the pilot tone modulation depth. It can be learned from the foregoing descriptions that the driving signal includes one or more of a pilot tone modulation current, a modulation current, and a bias current. A relationship between the driving signal and the pilot tone modulation depth H may be represented by using the following Formula 2, Formula 3, or Formula 4.

$$H = \frac{I_{tone}}{2(I_{bias} + I_{mod} - i_{th}) + I_{tone}} \qquad \text{Formula 2}$$

$$H = \frac{I_{tone}}{2\left(I_{bias} + \frac{1}{2}I_{mod} - i_{th}\right) + I_{tone}} \qquad \text{Formula 3}$$

$$H = \frac{I_{tone}}{2(I_{bias} - i_{th}) + I_{tone}} \qquad \text{Formula 4}$$

$I_{tone}$ represents the pilot tone modulation current. $I_{mod}$ represents the modulation current. $I_{bias}$ represents the bias current. $i_{th}$ represents a threshold current. It can be learned from the foregoing descriptions that the laser 101 may be a directly modulated laser or an externally modulated laser. A coupling manner of the laser 101 includes direct-current coupling and alternating-current coupling. For a directly modulated laser that is direct-current coupled, the processor 103 may be configured to obtain the pilot tone modulation depth H according to Formula 2. For a directly modulated laser that is alternating-current coupled, the processor 103 may be configured to obtain the pilot tone modulation depth H according to Formula 3. For the externally modulated laser, the pilot tone modulation current may be loaded on the bias current of the laser 101. In this case, the processor 103 may be configured to obtain the pilot tone modulation depth H according to Formula 4.

It can be learned from Formula 2 and Formula 3 that, the threshold current, the pilot tone modulation current, the modulation current, and the bias current all affect a value of the pilot tone modulation depth. However, the threshold current of the laser cannot be adjusted. Therefore, the processor 103 may be configured to change one or more of the pilot tone modulation current, the modulation current, and the bias current based on the pilot tone modulation depth.

It can be learned from Formula 4 that, the threshold current, the pilot tone modulation current, and the bias current all affect a value of the pilot tone modulation depth. However, the threshold current of the laser cannot be adjusted. Therefore, the processor 103 may be configured to change one or both of the pilot tone modulation current and the bias current based on the pilot tone modulation depth.

In an actual application, the driving circuit 104 may include a laser driving circuit and a pilot tone modulation generation circuit. The processor 103 may change one or more of the pilot tone modulation current, the modulation current, and the bias current through the laser driving circuit and the pilot tone modulation generation circuit. FIG. 2 is a second diagram of a structure of an optical transmitter module according to an embodiment of this application. As shown in FIG. 2, based on FIG. 1, the driving circuit 104 includes the laser driving circuit 201 and the pilot tone modulation generation circuit 202. The laser driving circuit 201 is configured to generate the modulation current and the bias current. The pilot tone modulation generation circuit 202 is configured to generate the pilot tone modulation current. The processor 103 is connected to the laser driving circuit 201 and the pilot tone modulation generation circuit 202. The processor 103 may be configured to change the modulation current or the bias current of the laser driving circuit 201 based on the pilot tone modulation depth. The processor 103 may be further configured to change the pilot tone modulation current of the pilot tone modulation generation circuit 202 based on the pilot tone modulation depth.

In an actual application, the processor 103 may be configured to obtain a target pilot tone modulation depth range. The processor 103 is configured to change the driving signal based on the pilot tone modulation depth and the target pilot tone modulation depth range. Specifically, when the pilot tone modulation depth is not within the target pilot tone modulation depth range, the processor 103 is configured to change the driving signal of the driving circuit 104 based on the pilot tone modulation depth. When the pilot tone modulation depth is within the target pilot tone modulation depth range, the processor 103 does not need to change the driving signal of the driving circuit 104. For example, the target pilot tone modulation depth range is 6% to 10%. When the pilot tone modulation depth H is 7%, the processor 103 does not need to change the driving signal of the driving circuit 104. When the pilot tone modulation depth H obtained by the processor 103 is 5%, the processor 103 is configured to change the driving signal of the driving circuit 104, to increase the pilot tone modulation depth of the pilot tone modulation signal. When the pilot tone modulation depth H obtained by the processor 103 is 11%, the processor 103 is configured to change the driving signal of the driving circuit 104, to reduce the pilot tone modulation depth of the pilot tone modulation signal.

It should be understood that, according to Formulas 2 to 4, it can be learned that one or both of the modulation current and the bias current are reduced, or one or both of the pilot tone modulation current and the threshold current are increased, so that the pilot tone modulation depth of the pilot tone modulation signal can be increased. On the contrary, one or both of the modulation current and the bias current are increased, or one or both of the pilot tone modulation current and the threshold current are reduced, so that the pilot tone modulation depth of the pilot tone modulation signal can be reduced.

It should be understood that, in this embodiment of this application, the optical transmitter module 100 may periodically adjust the pilot tone modulation depth of the pilot tone modulation signal. For example, after the driving signal of the driving circuit 104 is changed, the driving circuit 104 is configured to drive the laser 101 based on a changed driving signal. The laser 101 outputs a backward optical signal and a forward optical signal based on the changed driving signal. The photoelectric detector 102 is configured to convert the backward optical signal into an analog electrical signal again. The processor 103 is configured to convert the analog electrical signal into a digital electrical signal again. The processor 103 is further configured to obtain the pilot tone modulation depth of the pilot tone modulation signal again based on the digital electrical signal. If the pilot tone modulation depth is not within the target pilot tone modulation depth range, the processor 103 is further configured to change the driving signal again based on the pilot tone modulation depth. The driving circuit 104 is configured to drive the laser 101 again based on the changed driving signal.

In an actual application, affected by quality of a communication link and an optical receiving device, an acceptance range of the optical receiving device for the pilot tone modulation depth may be different. For example, when the pilot tone modulation depth ranges from 6% to 10%, a first optical receiving device normally receives the pilot tone modulation signal, and a second optical receiving device cannot normally receive the pilot tone modulation signal. Therefore, to improve communication reliability, the optical transmitter module may adjust the target pilot tone modulation depth range based on feedback of the optical receiving device.

In a possible manner, the optical transmitter module 100 receives a target signal from the optical receiving device. The target signal indicates that a received bit error rate or a signal-to-noise ratio of the pilot tone modulation signal does not satisfy a first condition. For example, the received bit error rate is greater than a threshold, or the signal-to-noise ratio is less than a threshold. The processor 103 is configured to obtain the target signal, and adjust the target pilot tone modulation depth range based on the target signal, to increase an average pilot tone modulation depth of the pilot tone modulation signal. The average pilot tone modulation depth is an average value of the target pilot tone modulation depth range. For example, when the target pilot tone modulation depth range is 6% to 10%, the average pilot tone modulation depth of the pilot tone modulation signal is 8%. When the target pilot tone modulation depth range is 8% to 10%, the average pilot tone modulation depth of the pilot tone modulation signal is 9%.

In another possible manner, the optical transmitter module 100 receives a target signal from the optical receiving device. The target signal indicates that a received bit error rate or a signal-to-noise ratio of the service signal does not satisfy a first condition. For example, the received bit error rate is greater than a threshold, or the signal-to-noise ratio is less than a threshold. The processor 103 is configured to obtain the target signal, and adjust the target pilot tone modulation depth range based on the target signal, to reduce an average pilot tone modulation depth of the pilot tone modulation signal.

In an actual application, when the optical transmitter module 100 is just powered on, the optical transmitter module 100 needs to transmit a handshake signal to the optical receiving device by using the pilot tone modulation signal. To improve a handshake success rate, the optical transmitter module 100 may increase the pilot tone modulation depth. Specifically, the processor 103 is further configured to receive the power-on signal, and change the driving signal based on the pilot tone modulation depth and the power-on signal, to increase the pilot tone modulation depth of the pilot tone modulation signal.

In an actual application, the optical transmitter module 100 may encounter some emergencies. An emergency may affect subsequent data transmission. For example, the emergency may be an alert of an excessively high optical power of the laser, an alert of an excessively low optical power of the laser, an alert of a loss of service information, and an alert of a sudden power failure. To improve reliability of transmitting alert information and facilitate maintenance personnel to determine a fault location, the optical transmitter module 100 may increase the pilot tone modulation depth. Specifically, the processor 103 is further configured to receive a target alert. The target alert includes any one or more of the following alerts: an alert of an excessively high optical power of the laser (also referred to as an alert of an excessively high output optical power of the laser), an alert of an excessively low optical power of the laser (also referred to as an alert of an excessively low output optical power of the laser), an alert of a loss of service information, and an alert of a sudden power failure. The processor 103 is configured to change the driving signal based on the pilot tone modulation depth and the target alert, to increase the pilot tone modulation depth of the pilot tone modulation signal. The pilot tone modulation signal carries related information of the target alert. For example, the pilot tone modulation signal carries an alert code corresponding to the target alert.

In this embodiment of this application, the pilot tone modulation depth of the pilot tone modulation signal is adjusted by using the backward optical signal of the laser, so that impact of an operating temperature change or aging of the laser on the pilot tone modulation depth can be reduced, thereby improving the communication reliability. In addition, because the pilot tone modulation depth may be adjusted in real time based on feedback of the backward optical signal, a pilot tone modulation depth of the laser does not need to be calibrated through an external device before delivery. Therefore, in this embodiment of this application, production costs of the optical transmitter module can be further reduced. In addition, the calibrated pilot tone modulation depth may be affected by a temperature during calibration, noise of a calibration device, differences between calibration devices, and a calibration method. Consequently, calibration precision may be poor. In this embodiment of this application, through periodic feedback adjustment, accuracy of the pilot tone modulation depth can be increased.

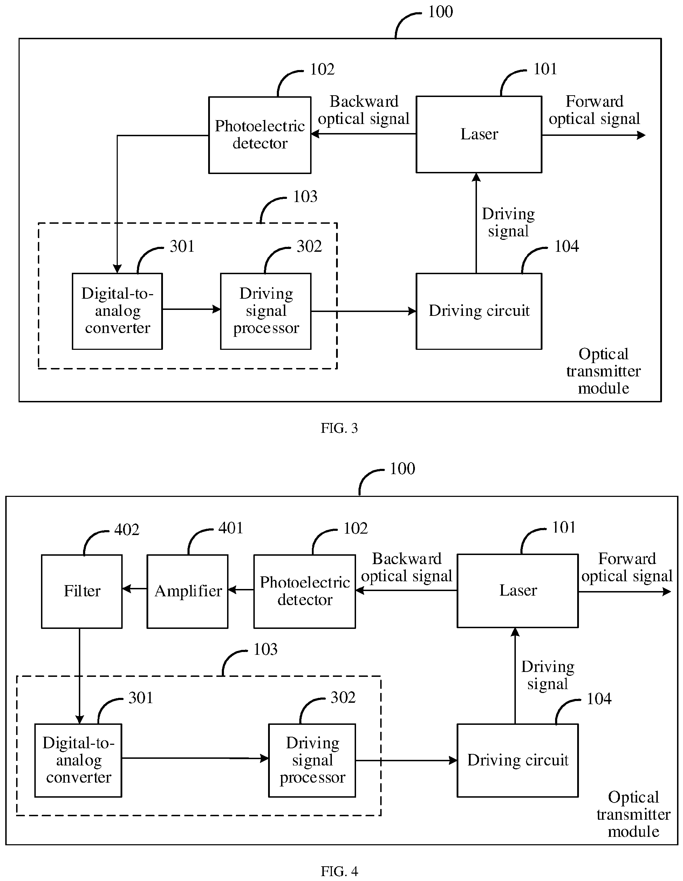

FIG. 3 is a third diagram of a structure of an optical transmitter module according to an embodiment of this application. As shown in FIG. 3, based on FIG. 1, the processor 103 includes a digital-to-analog converter 301 and a driving signal processor 302. The digital-to-analog converter 301 is configured to receive the analog electrical signal from the photoelectric detector 102, and convert the analog electrical signal into the digital electrical signal. The driving signal processor 302 may be an MCU, a DSP, an FPGA, or the like. The driving signal processor 302 is configured to receive the digital electrical signal from the digital-to-analog converter 301, and obtain the pilot tone modulation depth of the pilot tone modulation signal based on the digital electrical signal. The driving signal processor 302 is further configured to change the driving signal of the driving circuit 104 based on the pilot tone modulation depth.

In FIG. 3, the digital-to-analog converter 301 and the driving signal processor 302 are disposed independently. In an actual application, the digital-to-analog converter 301 may be integrated inside the driving signal processor 302. In this case, the driving signal processor 302 is also referred to as a processor. The driving signal processor 302 is configured to perform steps that can be performed by the digital-to-analog converter 301. For example, the driving signal processor 302 is configured to receive the analog electrical signal from the photoelectric detector 102, and convert the analog electrical signal into the digital electrical signal.

In an actual application, a power of the backward optical signal is relatively low. Therefore, the processor 103 may fail to correctly obtain the pilot tone modulation depth of the pilot tone modulation signal. To improve accuracy of the obtained pilot tone modulation depth, the optical transmitter module 100 may amplify the analog electrical signal through an amplifier. FIG. 4 is a fourth diagram of a structure of an optical transmitter module according to an embodiment of this application. As shown in FIG. 4, based on FIG. 3, the optical transmitter module 100 further includes an amplifier 401 and a filter 402. The amplifier 401 may be a trans-impedance amplifier or an operational amplifier. The amplifier 401 is configured to receive the analog electrical signal from the photoelectric detector 102, and amplify the analog electrical signal. The filter 402 may be a low-pass filter. The filter 402 is configured to receive an amplified analog electrical signal from the amplifier 401, and filter the amplified analog electrical signal. The filter 402 is further configured to transmit a filtered analog electrical signal to the processor 103. The amplified analog electrical signal carries a glitch signal. In addition, it can be learned from the foregoing descriptions in FIG. 1 that the analog electrical signal further includes a high-frequency service signal. By introducing the filter 402, impact of the service signal and the glitch signal on the pilot tone modulation signal can be reduced, thereby improving accuracy of the digital electrical signal obtained through conversion.

It should be understood that an optical transmitting module in FIG. 1 to FIG. 4 is merely an example provided in embodiments of this application. In an actual application, a person skilled in the art may make an example modification to a structure of the optical transmitting module based on a requirement. For example, in FIG. 2, the optical transmitting module 100 further includes the amplifier. For another example, in FIG. 3, the driving circuit 104 may include the laser driving circuit 201 and the pilot tone modulation generation circuit 202. For another example, in FIG. 4, the optical transmitting module 100 does not include the filter.

In an actual application, the laser 101 has a specific service life, and may fail during operation. To predict failure time of the laser, facilitate operation and maintenance personnel to replace the laser in advance, and ensure normal service communication, an embodiment of this application provides an optical transmitter module. The optical transmitter module can warn the service life of the laser in advance. For a structure of the optical transmitter module, refer to the descriptions in any one of FIG. 1 to FIG. 4. The following uses the optical transmitter module in FIG. 1 as an example for description.

As shown in FIG. 1, the optical transmitter module 100 includes the laser 101, the photoelectric detector 102, the processor 103, and the driving circuit 104. It should be understood that, for descriptions of components in the optical transmitter module 100, refer to the related descriptions in FIG. 1 to FIG. 4. The laser 101 is configured to output the forward optical signal and the backward optical signal based on the driving signal of the driving circuit 104. The forward optical signal and the backward optical signal carry a pilot tone modulation signal. The pilot tone modulation signal is obtained based on the driving signal. The photoelectric detector 102 is configured to convert the backward optical signal into the analog electrical signal. The processor 103 is configured to convert the analog electrical signal into the digital electrical signal. The processor 103 is further configured to obtain the pilot tone modulation depth H of the pilot tone modulation signal based on the digital electrical signal.

The processor 103 is further configured to obtain a first threshold current of the laser 101 based on the pilot tone modulation depth H and the driving signal. For example, the processor 103 may obtain the first threshold current according to any one of Formula 2 to Formula 4. For example, in Formula 2, a value of the pilot tone modulation depth H may be obtained according to Formula 1. The modulation current, the bias current, and the pilot tone modulation current are driving signals output by the driving circuit. The processor 103 may obtain a value of the driving signal, that is, values of the modulation current, the bias current, and the pilot tone modulation current. Therefore, the processor 103 may obtain the first threshold current according to Formula 2. Similarly, at another moment, the processor 103 may obtain a second threshold current of the laser 101 by using a similar method.

When the first threshold current and the second threshold current satisfy a second condition, the processor 103 is further configured to generate a service life warning of the laser 101 based on the first threshold current and the second threshold current. For example, the second condition may be that first coordinates and second coordinates are on a service life curve. The first coordinates are (X, Y), where X and Y represent any value. The second coordinates are (X+T, Y +($i_{th2}$-$i_{th1}$)). T represents a difference between a second moment and a first moment. The processor 103 obtains the first threshold current at the first moment. The processor 103 obtains the second threshold current at the second moment. $i_{th2}$ represents the second threshold current. $i_{th1}$ represents the first threshold current. For another example, the second condition may be that a difference between the first threshold current and the second threshold current is greater than a threshold. After a service life alert is generated, the optical transmitter module 100 may send the service life alert to a network management device. The network management device may determine the service life of the laser 101 based on the service life alert. Before the service life ends, the maintenance personnel may replace the laser 101 in advance, to ensure normal service communication.

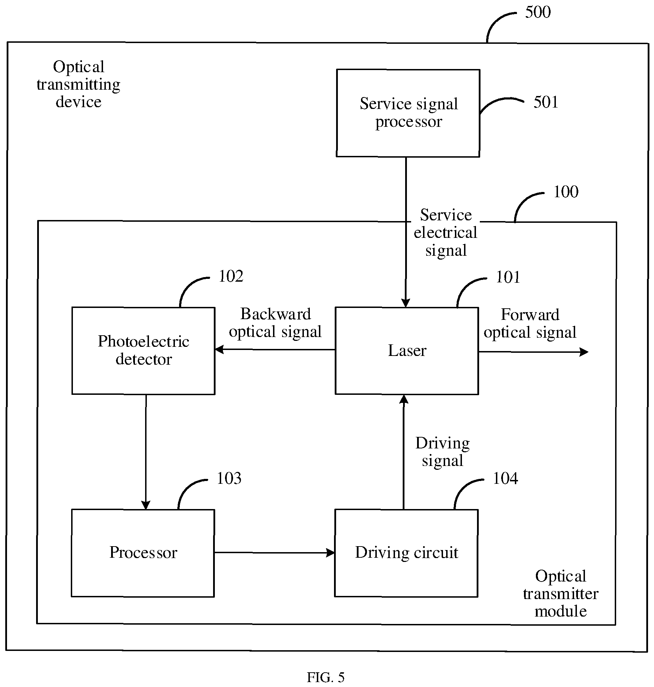

The foregoing describes the optical transmitter module provided in embodiments of this application, and the following describes the optical transmitting device provided in embodiments of this application. FIG. 5 is a diagram of a structure of an optical transmitting device according to an embodiment of this application. As shown in FIG. 5, an optical transmitting device 500 includes the optical transmitter module 100 and a service signal processor 501. For descriptions of the optical transmitter module 100, refer to the descriptions in any one of FIG. 1 to FIG. 4 (where the optical transmitter module 100 in FIG. 1 is used as an example herein). The service signal processor 501 may be a central processing unit (central processing unit, CPU), a network processor (network processor, NP), or a combination of a CPU and an NP. The service signal processor 501 may alternatively be a graphic processing unit (graphic processing unit, GPU). The service signal processor 501 may further include a hardware chip or another general-purpose processor. The foregoing hardware chip may be an application specific integrated circuit (application specific integrated circuit, ASIC), a programmable logic device (programmable logic device, PLD), or a combination thereof. The service signal processor 501 is configured to transmit a service electrical signal to the laser 101. It can be learned from the foregoing descriptions in FIG. 1 that the laser 101 may further receive the driving signal from the driving circuit 104. Therefore, the laser 101 may output the forward optical signal and the backward optical signal based on the driving signal and the service electrical signal. The forward optical signal and the backward optical signal carry same information. The forward optical signal includes a pilot tone modulation signal and a service signal. The pilot tone modulation signal is obtained based on the driving signal. The service signal is obtained based on the service electrical signal.

In an actual application, the optical transmitting device 500 may further include a memory. The memory may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), a flash memory, or the like. The volatile memory may be a random access memory (random access memory, RAM). The memory is connected to the optical transmitter module 100 and the service signal processor 501. The memory may store a target pilot tone modulation depth range, a service life curve, service data, or the like. The processor 103 may be configured to obtain the target pilot tone modulation depth range or the service life curve from the memory. The service signal processor 501 may be configured to obtain the service data from the memory, and obtain the service electrical signal based on the service data.

It should be understood that, in an actual application, the optical transmitting device 500 may further include an optical receiver module. The optical receiver module and the optical transmitter module 100 may be disposed independently. The optical receiver module and the optical transmitter module 100 may alternatively be integrated on a same board. In this case, the optical receiver module and the optical transmitter module 100 are collectively referred to as an optical transceiver module. Therefore, in this embodiment of this application, the optical transmitter module 100 may also be referred to as an optical transceiver module.

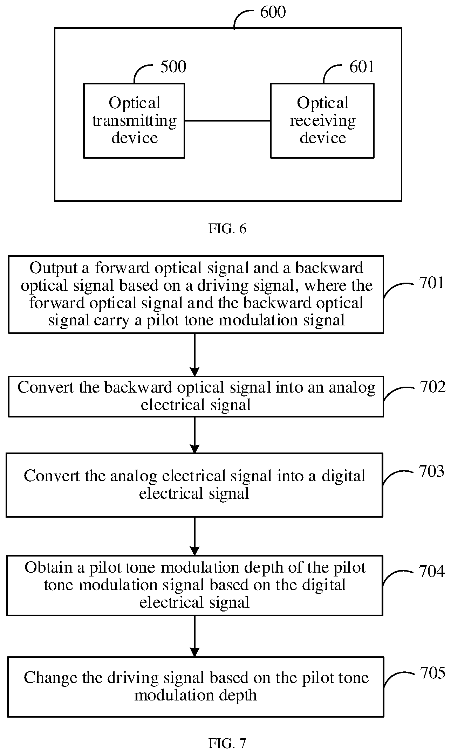

FIG. 6 is a diagram of a structure of an optical communication system according to an embodiment of this application. As shown in FIG. 6, an optical communication system 600 includes the optical transmitting device 500 and an optical receiving device 601. The optical transmitting device 500 and the optical receiving device 601 are connected through an optical fiber. For the optical transmitting device 500, refer to the descriptions in FIG. 5. The optical transmitting device 500 is configured to transmit a forward optical signal to the optical receiving device 601. The forward optical signal includes a pilot tone modulation signal and a service signal. The optical receiving device 601 is configured to receive the forward optical signal from the optical transmitting device 500. It should be understood that the optical receiving device 601 may alternatively transmit a forward optical signal to the optical transmitting device 500. Therefore, for descriptions of the optical receiving device 601, refer to the descriptions of the optical transmitting device 500.

FIG. 7 is a schematic flowchart of a method for adjusting a pilot tone modulation depth according to an embodiment of this application. As shown in FIG. 7, the method for adjusting a pilot tone modulation depth includes the following steps. The method for adjusting a pilot tone modulation depth may be applied to an optical transmitter module or an optical transmitting device. An example in which the method for adjusting a pilot tone modulation depth is applied to the optical transmitting device is used for description below.

In step 701, the optical transmitting device outputs a forward optical signal and a backward optical signal based on the driving signal. The forward optical signal and the backward optical signal carry a pilot tone modulation signal. The pilot tone modulation signal is obtained based on the driving signal. The driving signal includes one or more of a threshold current, a pilot tone modulation current, a modulation current, and a bias current. The optical transmitting device includes a laser. By receiving the driving signal, the laser outputs a forward optical signal and a backward optical signal. The forward optical signal and the backward optical signal carry same information. In an actual application, the laser may further receive a service electrical signal. In this case, the forward optical signal and the backward optical signal each further carry a service signal.

In step 702, the optical transmitting device converts the backward optical signal into an analog electrical signal. The optical transmitting device includes a photoelectric detector. The optical transmitting device converts the backward optical signal into the analog electrical signal through the photoelectric detector.

In step 703, the optical transmitting device converts the analog electrical signal into a digital electrical signal. The optical transmitting device includes a digital-to-analog converter. The optical transmitting device converts the analog electrical signal into the digital electrical signal through the digital-to-analog converter.

In step 704, the optical transmitting device obtains a pilot tone modulation depth of the pilot tone modulation signal based on the digital electrical signal. The optical transmitting device may obtain an energy amplitude P1 and an average power (P1+P0)/2 of the digital electrical signal. According to Formula 2, the optical transmitting device obtains the pilot tone modulation depth H based on the energy amplitude and the average power.

In step 705, the optical transmitting device changes the driving signal based on the pilot tone modulation depth. It can be learned from Formula 2 that, the threshold current, the pilot tone modulation current, the modulation current, and the bias current all affect a value of the pilot tone modulation depth. Therefore, the optical transmitting device may be configured to change one or more of the threshold current, the pilot tone modulation current, the modulation current, and the bias current based on the pilot tone modulation depth. For example, when the pilot tone modulation depth is excessively large, the optical transmitting device increases one or both of the modulation current and the bias current. When the pilot tone modulation depth is excessively small, the optical transmitting device reduces one or both of the modulation current and the bias current.

It should be understood that, for the method for adjusting a pilot tone modulation depth, refer to the foregoing descriptions of the optical transmitter module and the optical transmitting device. For example, the optical transmitting device changes the driving signal based on a target pilot tone modulation depth range and the pilot tone modulation depth. For another example, before converting the analog electrical signal into the digital electrical signal, the optical transmitting device amplifies the analog electrical signal through the amplifier. For another example, the optical transmitting device receives a target signal from an optical receiving device. The target signal indicates that a received bit error rate or a signal-to-noise ratio of the pilot tone modulation signal does not satisfy a first condition. The optical transmitting device adjusts the target pilot tone modulation depth range based on the target signal, to increase an average pilot tone modulation depth of the pilot tone modulation signal.

In this embodiment of this application, the optical transmitting device may periodically perform steps 701 to 705. For example, after changing the driving signal, the optical transmitting device outputs a changed forward optical signal and a changed backward optical signal based on a changed driving signal. The changed forward optical signal and the changed backward optical signal carry a changed pilot tone modulation signal. The optical transmitting device converts the changed backward optical signal into a changed analog electrical signal. The optical transmitting device converts the changed analog electrical signal into a changed digital electrical signal. The optical transmitting device obtains a changed pilot tone modulation depth based on the changed digital electrical signal. The optical transmitting device changes the changed driving signal based on the changed pilot tone modulation depth.

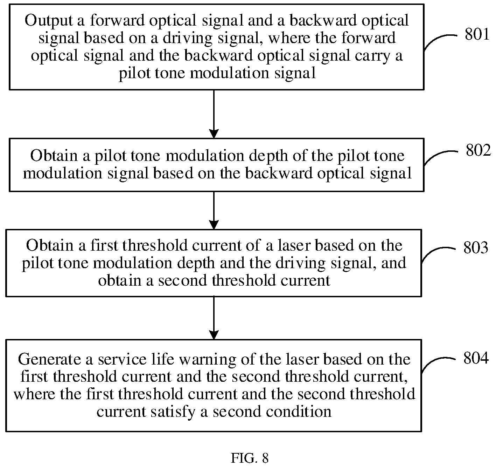

FIG. 8 is a schematic flowchart of a method for generating a service life warning according to an embodiment of this application. As shown in FIG. 8, the method for generating a service life warning includes the following steps. The method for generating a service life warning may be applied to an optical transmitter module or an optical transmitting device. An example in which the method for generating a service life warning is applied to the optical transmitting device is used for description below.

In step 801, the optical transmitting device outputs a forward optical signal and a backward optical signal based on a driving signal, where the forward optical signal and the backward optical signal carry a pilot tone modulation signal.

In step 802, the optical transmitting device obtains a pilot tone modulation depth of the pilot tone modulation signal based on the backward optical signal. For descriptions of step 802 and step 801, refer to the descriptions of step 701 to step 704.

In step 803, the optical transmitting device obtains a first threshold current of a laser based on the pilot tone modulation depth and the driving signal, and obtains a second threshold current. For example, the optical transmitting device may obtain the first threshold current according to Formula 2. Similarly, at another moment, the optical transmitting device obtains the second threshold current of the laser.

In step 804, the optical transmitting device generates a service life warning of the laser based on the first threshold current and the second threshold current. The first threshold current and the second threshold current satisfy a second condition. After a service life alert is generated, the optical transmitting device may send the service life alert to a network management device. The network management device may determine a service life of the laser based on the service life alert. Before the service life ends, maintenance personnel may replace the laser in advance, to ensure normal service communication.

It should be understood that for the method for generating a service life warning, refer to the foregoing descriptions of the optical transmitter module and the optical transmitting device. For example, the second condition may be that first coordinates and second coordinates are on a service life curve. The first coordinates are (X, Y). X and Y represent any value. The second coordinates are $(X+T, Y+(i_{th2}-i_{th1}))$. For another example, the optical transmitting device may further change the driving signal based on the pilot tone modulation depth.

The foregoing descriptions are merely specific implementations of this application, but are not intended to limit the protection scope of this application. Any variation or replacement readily figured out by a person skilled in the art within the technical scope disclosed in this application shall fall within the protection scope of this application.

**Claims**

1. An optical transmitter module, comprising a laser, a photoelectric detector, a processor, and a driving circuit, wherein

   the laser is configured to output a forward optical signal and a backward optical signal based on a driving signal of the driving circuit, wherein the forward optical signal and the backward optical signal carry a pilot tone modulation signal;
   the photoelectric detector is configured to convert the backward optical signal into an analog electrical signal;
   the processor is configured to convert the analog electrical signal into a digital electrical signal;
   the processor is further configured to obtain a pilot tone modulation depth of the pilot tone modulation signal based on the digital electrical signal, and change the driving signal based on the pilot tone modulation depth; and
   the driving circuit is configured to drive the laser based on a changed driving signal.

2. The optical transmitter module according to claim 1, wherein the optical transmitter module further comprises an amplifier;

   the amplifier is configured to amplify the analog electrical signal; and
   that the digital-to-analog converter is configured to convert the analog electrical signal into a digital electrical signal comprises: the digital-to-analog converter is configured to convert an amplified analog electrical signal into the digital electrical signal.

3. The optical transmitter module according to claim 1, wherein the optical transmitter module further comprises a filter;

   the filter is configured to filter the analog electrical signal; and
   that the digital-to-analog converter is configured to convert the analog electrical signal into a digital electrical signal comprises: the digital-to-analog converter is configured to convert a filtered analog electrical signal into the digital electrical signal.

4. The optical transmitter module according to any one of claims 1 to 3, wherein

that the processor is configured to change the driving signal based on the pilot tone modulation depth comprises: the processor is configured to change the driving signal based on the pilot tone modulation depth and a target pilot tone modulation depth range, wherein the pilot tone modulation depth is not within the target pilot tone modulation depth range.

5. The optical transmitter module according to claim 4, wherein the processor is further configured to receive a target signal, wherein the target signal indicates that a received bit error rate or a signal-to-noise ratio of the pilot tone modulation signal does not satisfy a first condition; and
the processor is further configured to adjust the target pilot tone modulation depth range based on the target signal, to increase an average pilot tone modulation depth of the pilot tone modulation signal.

6. The optical transmitter module according to any one of claims 1 to 5, wherein

the processor is further configured to receive a power-on signal; and
that the processor is configured to change the driving signal based on the pilot tone modulation depth comprises: the processor is configured to change the driving signal based on the pilot tone modulation depth and the power-on signal, to increase the pilot tone modulation depth of the pilot tone modulation signal.

7. The optical transmitter module according to any one of claims 1 to 5, wherein the processor is further configured to receive a target alert, wherein the target alert comprises any one or more of the following alerts: an alert of an excessively high optical power of the laser, an alert of an excessively low optical power of the laser, an alert of a loss of service information, and an alert of a sudden power failure; and
that the processor is configured to change the driving signal based on the pilot tone modulation depth comprises: the processor is configured to change the driving signal based on the pilot tone modulation depth and the target alert, to increase the pilot tone modulation depth of the pilot tone modulation signal, wherein the pilot tone modulation signal carries related information of the target alert.

8. The optical transmitter module according to any one of claims 1 to 7, wherein

the processor is further configured to obtain a first threshold current of the laser based on the driving signal and the pilot tone modulation depth; and
the processor is further configured to obtain a second threshold current of the laser, and generate a service life warning of the laser based on the first threshold current and the second threshold current, wherein the first threshold current and the second threshold current satisfy a second condition.

9. An optical transmitting device, comprising a service signal processor and the optical transmitter module according to any one of claims 1 to 8, wherein

the service signal processor is configured to transmit a service electrical signal to the optical transmitter module; and
the optical transmitter module is configured to output a forward optical signal and a backward optical signal based on the service electrical signal, wherein the forward optical signal and the backward optical signal carry a service signal.

10. A method for adjusting a pilot tone modulation depth, comprising:

outputting a forward optical signal and a backward optical signal based on a driving signal, wherein the forward optical signal and the backward optical signal carry a pilot tone modulation signal;
converting the backward optical signal into an analog electrical signal;
converting the analog electrical signal into a digital electrical signal;
obtaining a pilot tone modulation depth of the pilot tone modulation signal based on the digital electrical signal; and
changing the driving signal based on the pilot tone modulation depth.

11. The method according to claim 10, wherein the method further comprises:

amplifying the analog electrical signal, to obtain an amplified analog electrical signal; and
the converting the analog electrical signal into a digital electrical signal comprises: converting the amplified analog electrical signal into the digital electrical signal.

**12.** The method according to claim 10, wherein the method further comprises:

filtering the analog electrical signal, to obtain a filtered analog electrical signal; and
the converting the analog electrical signal into a digital electrical signal comprises: converting the filtered analog electrical signal into the digital electrical signal.

**13.** The method according to any one of claims 10 to 12, wherein
the changing the driving signal based on the pilot tone modulation depth comprises: changing the driving signal based on the pilot tone modulation depth and a target pilot tone modulation depth range, wherein the pilot tone modulation depth is not within the target pilot tone modulation depth range.

**14.** The method according to claim 13, wherein the method further comprises:

receiving a target signal, wherein the target signal indicates that a received bit error rate or a signal-to-noise ratio of the pilot tone modulation signal does not satisfy a first condition; and
adjusting the target pilot tone modulation depth range based on the target signal, to increase an average pilot tone modulation depth of the pilot tone modulation signal.

**15.** The method according to any one of claims 10 to 14, wherein the method further comprises:

receiving a power-on signal; and
the changing the driving signal based on the pilot tone modulation depth comprises: changing the driving signal based on the pilot tone modulation depth and the power-on signal, to increase the pilot tone modulation depth of the pilot tone modulation signal.

**16.** The method according to any one of claims 10 to 14, wherein the method further comprises:

receiving a target alert, wherein the target alert comprises any one or more of the following alerts: an alert of an excessively high optical power of a laser, an alert of an excessively low optical power of the laser, an alert of a loss of service information, and an alert of a sudden power failure; and
the changing the driving signal based on the pilot tone modulation depth comprises: changing the driving signal based on the pilot tone modulation depth and the target alert, to increase the pilot tone modulation depth of the pilot tone modulation signal, wherein the pilot tone modulation signal carries related information of the target alert.

**17.** The method according to any one of claims 10 to 16, wherein the method further comprises:

outputting a changed forward optical signal and a changed backward optical signal based on a changed driving signal, wherein the changed forward optical signal and the changed backward optical signal carry a changed pilot tone modulation signal;
converting the changed backward optical signal into a changed analog electrical signal;
converting the changed analog electrical signal into a changed digital electrical signal;
obtaining a changed pilot tone modulation depth based on the changed digital electrical signal; and
changing the changed driving signal based on the changed pilot tone modulation depth.

**18.** The method according to claim 17, wherein the method further comprises:

obtaining a first threshold current based on the driving signal and the pilot tone modulation depth;
obtaining a second threshold current based on the changed driving signal and the changed pilot tone modulation depth;
generating a service life warning based on the first threshold current and the second threshold current, wherein the first threshold current and the second threshold current satisfy a second condition.

100

FIG. 1

100

FIG. 2

100

Backward
optical signal

Photoelectric
detector

102

Laser

101

Forward
optical signal

103

Digital-to-
analog
converter

301

Driving
signal
processor

302

Driving
signal

Driving circuit

104

Optical
transmitter
module

FIG. 3

100

Filter

402

Amplifier

401

Photoelectric
detector

102

Backward
optical signal

Laser

101

Forward
optical signal

103

Digital-to-
analog
converter

301

Driving
signal
processor

302

Driving
signal

Driving circuit

104

Optical
transmitter
module

FIG. 4

FIG. 5

600

```
┌─────────────────────────────────────────────────────────┐
│                                                         │
│     ┌ 500                        ┌ 601                   │
│   ┌──────────────┐            ┌──────────────┐           │
│   │   Optical    │            │   Optical    │           │
│   │ transmitting │────────────│  receiving   │           │
│   │   device     │            │    device    │           │
│   └──────────────┘            └──────────────┘           │
│                                                         │
└─────────────────────────────────────────────────────────┘
```

FIG. 6

```
┌──────────────────────────────────────────────┐
│ Output a forward optical signal and a backward │
│ optical signal based on a driving signal, where the│ ─ 701
│ forward optical signal and the backward optical │
│ signal carry a pilot tone modulation signal     │
└──────────────────────────────────────────────┘
                      │
                      ▼
┌──────────────────────────────────────────────┐
│ Convert the backward optical signal into an analog│ ─ 702
│ electrical signal                               │
└──────────────────────────────────────────────┘
                      │
                      ▼
┌──────────────────────────────────────────────┐
│ Convert the analog electrical signal into a digital│ ─ 703
│ electrical signal                               │
└──────────────────────────────────────────────┘
                      │
                      ▼
┌──────────────────────────────────────────────┐
│ Obtain a pilot tone modulation depth of the pilot │ ─ 704
│ tone modulation signal based on the digital       │
│ electrical signal                               │
└──────────────────────────────────────────────┘
                      │
                      ▼
┌──────────────────────────────────────────────┐
│ Change the driving signal based on the pilot tone │ ─ 705
│ modulation depth                                │
└──────────────────────────────────────────────┘
```

FIG. 7

Output a forward optical signal and a backward optical signal based on a driving signal, where the forward optical signal and the backward optical signal carry a pilot tone modulation signal    ⌐ 801

Obtain a pilot tone modulation depth of the pilot tone modulation signal based on the backward optical signal    ⌐ 802

Obtain a first threshold current of a laser based on the pilot tone modulation depth and the driving signal, and obtain a second threshold current    ⌐ 803

Generate a service life warning of the laser based on the first threshold current and the second threshold current, where the first threshold current and the second threshold current satisfy a second condition    ⌐ 804

FIG. 8

## EP 4 554 117 A1

## INTERNATIONAL SEARCH REPORT

| | International application No. |
|---|---|
| | **PCT/CN2023/105355** |

**A. CLASSIFICATION OF SUBJECT MATTER**

H04B10/50(2013.01)i

According to International Patent Classification (IPC) or to both national classification and IPC

**B. FIELDS SEARCHED**

Minimum documentation searched (classification system followed by classification symbols)

IPC: H04B

Documentation searched other than minimum documentation to the extent that such documents are included in the fields searched

Electronic data base consulted during the international search (name of data base and, where practicable, search terms used)

CNTXT, ENTXT, ENTXTC, CNABS, WPABS, DWPI, IEEE, 3GPP: 背光, 背向, 调顶, 后传, 后向, 信号, 前向, 驱动, 深度, 幅度, 光信号, 电信号, 模拟, 数字, 放大, 信噪比, back, top, signal, forward, drive, depth, amplitude, optical signal, electrical signal, analog, digital, amplification, signal-to-noise ratio, SNR

**C. DOCUMENTS CONSIDERED TO BE RELEVANT**

| Category* | Citation of document, with indication, where appropriate, of the relevant passages | Relevant to claim No. |
|---|---|---|
| A | CN 112437360 A (FUJIAN Z.K. LITECORE, LTD.) 02 March 2021 (2021-03-02) description, paragraphs [0006]-[0011], and figure 1 | 1-18 |
| A | CN 113783104 A (XIAMEN UX HIGH-SPEED IC CO., LTD.) 10 December 2021 (2021-12-10) entire document | 1-18 |
| A | CN 114679222 A (LUJIE TECHNOLOGY (GUANGZHOU) CO., LTD.) 28 June 2022 (2022-06-28) entire document | 1-18 |
| A | WO 2021004471 A1 (FIBERHOME TELECOMMUNICATION TECHNOLOGIES CO., LTD.) 14 January 2021 (2021-01-14) entire document | 1-18 |
| A | WO 2022100561 A1 (CHINA TELECOM CORPORATION LIMITED) 19 May 2022 (2022-05-19) entire document | 1-18 |

☐ Further documents are listed in the continuation of Box C.  ☑ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **10 October 2023** | **18 October 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

<div align="center">

**INTERNATIONAL SEARCH REPORT**

Information on patent family members

</div>

International application No.

**PCT/CN2023/105355**

| Patent document cited in search report | | | Publication date (day/month/year) | Patent family member(s) | | | Publication date (day/month/year) |
|---|---|---|---|---|---|---|---|
| CN | 112437360 | A | 02 March 2021 | None | | | |
| CN | 113783104 | A | 10 December 2021 | CN | 215732674 | U | 01 February 2022 |
| CN | 114679222 | A | 28 June 2022 | None | | | |
| WO | 2021004471 | A1 | 14 January 2021 | CN | 110430006 | A | 08 November 2019 |
| WO | 2022100561 | A1 | 19 May 2022 | CN | 114499738 | A | 13 May 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210937548